# EUROPEAN PATENT SPECIFICATION

(11) **EP 4 269 981 B1**
(45) Date of publication and mention of the grant of the patent: **18.11.2026**
(21) Application number: 21911500.3
(22) Date of filing: 22.12.2021
(51) Int. Cl.: G01R 31/40, G01M 13/003, H02M 7/483

(54) **APPARATUS FOR VALVE PERFORMANCE TEST OF MMC-BASED HVDC SYSTEM AND TEST METHOD THEREFOR**
VORRICHTUNG ZUR LEISTUNGSPRÜFUNG VON VENTILEN EINES AUF MMC BASIERENDEN HGÜ-SYSTEMS SOWIE PRÜFVERFAHREN HIERFÜR
DISPOSITIF D'ESSAI DE PERFORMANCE DE VANNES D'UN SYSTÈME HVDC À BASE DE MMC ET PROCÉDÉ D'ESSAI ASSOCIÉ

(30) Priority: 23.12.2020 KR 20200181698
(43) Date of publication of application: 01.11.2023
(73) Proprietor: Pukyong National University Industry - University Cooperation Foundation, Nam-gu Busan 48513 (KR)
(72) Inventor: NHO, Eui Cheol, Busan 48516 (KR); SEO, Byuong Jun, Busan 48432 (KR); JO, Kwang Rae, Geoje-si Gyeongsangnam-do 53296 (KR); HEO, Jin Yong, Busan 47192 (KR); KIM, Tae Jin, Gyeongsangnam-do 51543 (KR); LEE, Jong Pil, Gyeongsangnam-do 51543 (KR)
(74) Representative: Murgitroyd & Company
(86) International application number: PCT/KR2021/019559
(87) International publication number: WO 2022/139433

(56) References cited:
- EP-B1- 2 921 871
- JP-A- 2016 010 295
- KR-A- 20190 061 204
- KR-B1- 101 923 690
- KR-B1- 101 980 691
- US-A1- 2015 293 152
- US-A1- 2016 370 437

## Description

### [Technical Field]

The present disclosure relates to a valve performance test device for an MMC-based HVDC system and an MVDC system, and a test method therefor.

### [Background]

The statements in this section merely provide background information related to the present disclosure and do not necessarily constitute prior art.

Converters constituting a high voltage direct current (HVDC) system may be classified into a current source converter (CSC) and a voltage source converter (VSC). Among these, a VSC HVDC system is suitable for ultra-long distance transmission between countries because a long-distance power transmission loss is small, it is easy to link with renewable energy, and it is possible to perform independent control of active/reactive power. In particular, since a VSC HVDC system using a modular multi-level converter (MMC) has high scalability and conversion efficiency along with a medium voltage direct current (MVDC) system, application cases of the VSC HVDC system are increasing.

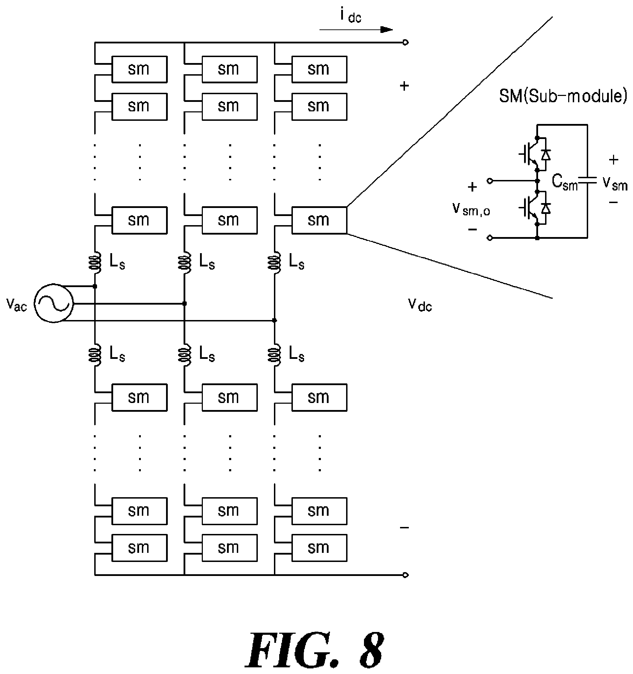

As illustrated in FIG. 8, an MMC-based HVDC system includes a plurality of arms, and each arm includes tens to hundreds of sub-modules (SMs). Since the MVDC has a lower voltage level than the HVDC, the MVDC includes a relatively smaller number of sub-modules, but has the same structure as the HVDC. Since a large number of sub-modules are included, it is very important to secure the reliability of the entire HVDC system and MVDC system on the basis of a performance test on a valve including a large number of sub-modules prior to manufacture or implementation of the HVDC system and MVDC system.

In order to secure the reliability of the MMC-based HVDC system, a test is performed on a per valve in which five or more sub-modules are generally connected in series, in consideration of time and cost aspects of a configuration of a performance test device, and IEC (International Electrotechnical Commission) 62501 is prescribed as an international standard. Pursuant to provisions for a valve performance test prescribed in IEC 62501, a current flowing in each arm of an HVDC system and an MVDC system should be simulated, and thus, a test current should include a second harmonic wave and a DC offset component, in addition to a fundamental wave.

Since a DC power supply of a test device accounts for most of a cost for the performance test device, there is a problem that the use of a high voltage DC power supply causes an increase in cost. An existing valve test device has a drawback that a valve test device can only provide a fundamental wave current and cannot supply a second harmonic wave and a DC offset component, and a DC supply voltage in the test device is very high, similarly to a voltage of an entire valve.

Therefore, in the performance test device for a valve, it is necessary to consider a test device that is capable of supplying a current to the valve similarly to an actual situation and has a low voltage value of a DC power supply.
US 2016/370437 describes a synthetic test circuit for a valve performance test of high-voltage direct current (HVDC), the synthetic test circuit comprises a resonance circuit configured to comprise a first test valve to test an operation of an inverter mode and a second test valve to test an operation of a rectifier mode. The synthetic test circuit may comprise a power supply (P/S) configured to provide the resonance circuit with an operating voltage. The synthetic test circuit may comprise a direct current/direct current (DC/DC) converter configured to bypass a DC offset current of the resonance circuit. The first test valve may be an inverter unit, which may have a positive DC current offset. Further, the second test valve may be a rectifier unit, which may have a negative DC current offset.

### [Disclosure]

### [Technical Problem]

The present disclosure in some embodiments seeks to provide a valve performance test device and a test method that generate a current for a valve performance test on the basis of a DC supply voltage lower than a voltage of a sub-module capacitor using an auxiliary valve including the same number of sub-modules as a large number of sub-modules (SM) included in a main valve that is a body under test. The valve performance test device and test method supply a current similar to a current of an actual HVDC system and an MVDC system to a valve on the basis of a remarkably low capacity in securing the reliability of the MMC-based HVDC system and MVDC system.

### [Technical Solution]

According to the present invention, there is provided a test device as claimed in claim 1. Also provided is a test method performed by a test device, as defined in claim 8. At least one aspect of the present disclosure provides a test device for testing a valve for a modular multilevel converter (MMC) based high voltage direct current (HVDC) system and a medium voltage direct current (MVDC) system. The test device comprises a main valve including n (n is a natural number) first sub-modules connected in series and configured to operate in a rectifier mode, wherein each of the first sub-modules has a structure including a half bridge or full bridge circuit including switches and diodes, and a sub-module capacitor. The test device also comprises an auxiliary valve including n second sub-modules connected in series and configured to operate in an inverter mode, wherein each of the second sub-modules has the same structure as the first sub-module. The test device also comprises an inverter configured to generate an AC voltage from a voltage of a DC power supply. The test device also comprises an inductor forming a loop with an input of the main valve, an output of the inverter, and an output of the auxiliary valve, a test current flowing through the inductor. The test device also comprises a control unit configured to control the inverter to control a circuit connection of the DC power supply, and to control the switches for the n first sub-modules and the n second sub-modules to control a circuit connection of the sub-module capacitor.

Another aspect of the present disclosure provides a test method performed by a test device to test a valve for a modular multi-level converter (MMC) based high voltage direct current (HVDC) system and a medium voltage direct current (MVDC) system. The test method comprises controlling an inverter to generate an AC voltage from a voltage of a DC power supply. The test method also comprises operating a main valve including n (n is a natural number) first sub-modules connected in series in a rectifier mode, wherein each of the first sub-modules has a structure including a half bridge or full bridge circuit including switches and diodes, and a sub-module capacitor. The test method also comprises operating an auxiliary valve including n second sub-modules connected in series in an inverter mode, wherein each of the second sub-modules has the same structure as the first sub-module. The test method also comprises generating a test current flowing through an inductor forming a loop with an input of the main valve, an output of the inverter, and an output of the auxiliary valve. The test method also comprises controlling the switches for the n first sub-modules and the n second sub-modules to control a circuit connection of the sub-module capacitor.

Another embodiment of the test method further comprises controlling a circuit connection of the main valve, the auxiliary valve, and the inverter for each of the n first sub-modules to implement a circuit equivalent to a boost converter, and controlling the switches to initially charge the sub-module capacitor with a voltage higher than a voltage of the DC power supply. The test method also comprises performing the initial charging on each of the n second sub-modules in the same manner as applied to the first sub-module.

### [Advantageous Effects]

As described above, the present disclosure provides a valve performance test device that generates a current for a valve performance test on the basis of a DC supply voltage lower than the voltage of the sub-module capacitor using the auxiliary valve including the same number of sub-modules as that in the main valve that is a body under test, to secure reliability in the valve performance test by supplying a current similar to a current actually flowing on an MMC-based HVDC system and an MVDC system on the basis of a remarkably low capacity.

Further, the present disclosure provides a valve performance test device that generates a current for a valve performance test on the basis of a DC supply voltage lower than the voltage of the sub-module capacitor using the auxiliary valve including the same number of sub-modules as that in the main valve that is a body under test, to simplify a configuration of a test circuit, to enhance the efficiency and reliability of a performance test, and to reduce a cost.

### [Brief Description of the Drawings]

FIG. 1 is a block diagram of a valve performance test device according to an embodiment of the present disclosure.
FIGS. 2a and 2b are block diagrams of a sub-module according to an embodiment of the present disclosure.
FIG. 3 is a block diagram of an inverter according to an embodiment of the present disclosure.
FIG. 4 is an illustrative diagram of an equivalent circuit for initial charging of the sub-module according to the embodiment of the present disclosure.
FIG. 5 is an illustrative diagram of switching modulation for voltage control of the sub-module according to the embodiment of the present disclosure.
FIG. 6 is a flowchart of a valve performance test method according to an embodiment of the present disclosure.
FIG. 7 is an illustrative diagram illustrating simulation results for a test device according to an embodiment of the present disclosure.
FIG. 8 is a diagram illustrating an MMC-based HVDC system including a plurality of sub-modules in one arm and a single sub-module with a half-bridge structure.

### [Detailed Description]

Hereinafter, some embodiments of the present disclosure are described in detail with reference to the accompanying illustrative drawings. In the following description, like reference numerals designate like elements, although the elements are shown in different drawings. Further, in the following description of some embodiments, detailed descriptions of related known components and functions when considered to obscure the subject of the present disclosure may be omitted for the purpose of clarity and for brevity.

Additionally, various terms such as first, second, (i), (ii), (a), (b), etc., are used solely to differentiate one component from the other but not to imply or suggest the substances, order, or sequence of the components. Throughout this specification, when a part 'includes' or 'comprises' a component, the part is meant to further include other components, not to exclude thereof unless specifically stated to the contrary.

The present embodiment discloses content regarding a valve performance test device for an MMC-based HVDC system and an MVDC systems. More specifically, the present embodiment provides a valve performance test device and a test method that generate a current for a valve performance test on the basis of a DC supply voltage lower than a voltage of a sub-module capacitor using an auxiliary valve including the same number of sub-modules as a large number of sub-modules (SM) included in a main valve that is a body under test. The valve performance test device and test method supply a current similar to a current of an actual HVDC system and an MVDC system to a valve on the basis of a remarkably low capacity in securing the reliability of the MMC-based HVDC system and MVDC system.

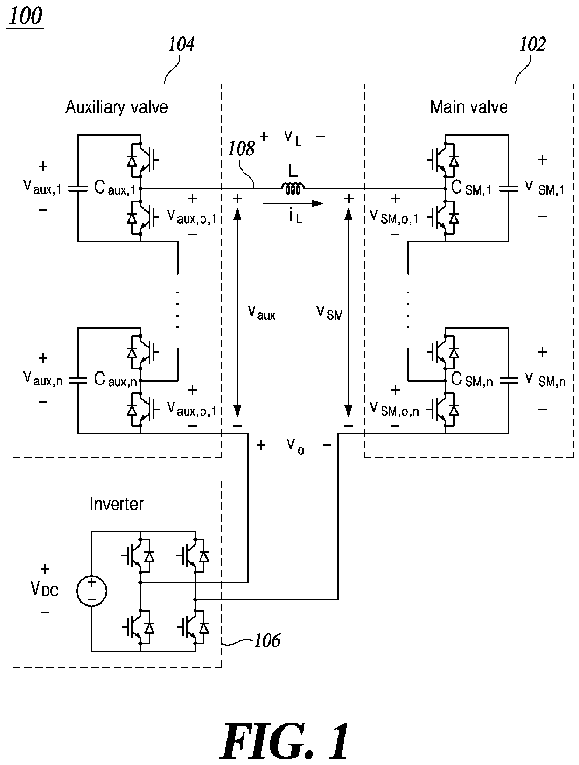

FIG. 1 is a block diagram of a valve performance test device according to an embodiment of the present disclosure.

A valve performance test device (100; hereinafter referred to as a 'test device') according to the present disclosure uses an auxiliary valve including the same number of sub-modules as that in a main valve, generates a test current including a second harmonic wave and a DC offset component on the basis of a supply voltage lower than a voltage of a submodule capacitor, and performs a valve performance test. The test device 100 includes a main valve 102, an auxiliary valve 104, an inverter 106, and an inductor 108. Here, components included in the test device 100 according to the present embodiment are not necessarily limited thereto. For example, the test device 100 may additionally include a control unit (not illustrated) for controlling operations of the components of the test device 100 or may be implemented in a form interlocked with an external control unit.

The main valve 102 is a performance test target and operates in a rectifier mode for converting AC to DC, and the auxiliary valve 104 operates in an inverter mode for converting DC to AC. The main valve 102 and the auxiliary valve 104 include the same number of (for example, n (n is a natural number)) SMs.

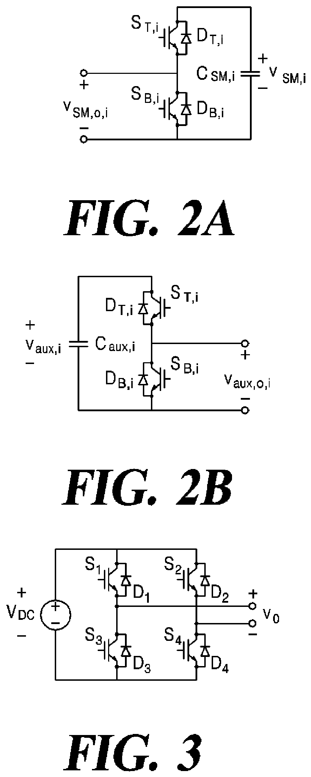

As illustrated in FIG. 2a, an i-th (natural number; 1 ≤ i ≤ n) SM included in the main valve 102 is implemented in the form of a half bridge, and includes a first circuit and a second circuit connected in parallel with each other. Here, the first circuit includes a first switch S_{T,i} and a sub-module capacitor C_{SM,i} connected in series, and the second circuit includes a second switch S_{B,i}. Further, reverse diodes D_{T,i} and D_{B,i} are connected in parallel to the respective switch S_{T,i} and S_{B,i} of the sub-module 110, respectively. In the example of FIG. 2a, the SM of the main valve 102 is implemented in a half bridge form, but is not necessarily limited thereto and may be implemented in a full bridge form.

As illustrated in FIG. 1, the second switches of the respective SMs included in the main valve 102 are connected in series. For example, a lower end of the second switch S_{B,i} of the i-th SM is connected to an upper end of the second switch S_{B,i+1} of the (i+1)-th SM. A voltage v_{SM} between an upper end of the second switch of the first SM of the main valve 102 and a lower end of the second switch of the n-th SM represents an input of the main valve 102 when the main valve 102 operates in the rectifier mode (thus, represents an output of the main valve 102 when the main valve 102 operates in the inverter mode).

Meanwhile, as illustrated in FIG. 2b, the i-th SM included in the auxiliary valve 104 is implemented in a half-bridge form and includes a first circuit and a second circuit connected in parallel to each other. Here, the first circuit includes a first switch S_{T,i} and a sub-module capacitor C_{aux,i} connected in series, and the second circuit includes a second switch S_{B,i}. Further, reverse diodes D_{T,i} and D_{B,i} are connected in parallel to the respective switches S_{T,i} and S_{B,i} of the sub-module 110, respectively. In the example of FIG. 2b, the SM of the auxiliary valve 104 is implemented in a half bridge form, but is not necessarily limited thereto and may be implemented in a full bridge form.

As illustrated in FIG. 1, the second switches of the respective SMs included in the auxiliary valve 104 are connected in series. A voltage vₐᵤₓ between an upper end of the second switch of the first SM of the auxiliary valve 104 and a lower end of the second switch of the n-th SM represents an output of the auxiliary valve 104 when the auxiliary valve 104 operates in the inverter mode (therefore, represents an input of the auxiliary valve 104 when the auxiliary valve 104 operates as in the rectifier mode).

The inverter 106 according to the present embodiment converts a DC supply voltage V_{DC} into an AC voltage to generate an AC voltage output vₒ. As illustrated in FIG. 3, the inverter 106 is implemented in a full bridge form and includes a first leg and a second leg connected in parallel. The first leg includes a first switch S₁ and a third switch S₃ connected in series in the same direction, and the second leg includes a second switch S₂ and a fourth switch S₄ connected in series in the same direction. Reverse diodes D1, D2, D3, and D4 are connected in parallel to the switches S1, S2, S3, and S4, respectively. In the example of FIG. 3, the inverter 106 is implemented in the full bridge form, but is not necessarily limited thereto and may be implemented in a half bridge form.

Meanwhile, the AC voltage output vₒ of the inverter 106 is generated from a junction between the first switch S₁ and the third switch S₃ and a junction between the second switch S₂ and the fourth switch S₄. The control unit may perform control so that switching of a first switch pair (S1 and S4) does not overlap switching of a second switch pair (S2 and S3), thereby generating the AC voltage output.

An output of the inverter 106 connects the input of main valve 102 in series with the output of the auxiliary valve 104. That is, the output of the inverter 106 is connected to the lower end of the second switch included in the n-th SM of the main valve 102 and the lower end of the second switch included in the n-th SM of the auxiliary valve 104.

The inductor 108 forms a loop with the input of the main valve 102, the output of the inverter, and the output of the auxiliary valve 104. The inductor 108 connects upper ends of the second switches of the first SMs of the main valve 102 and the auxiliary valve 104. An inductor voltage across the inductor 108 is v_{L}, and an inductor current flowing through the inductor 108 is i_{L}. Hereinafter, in the description of the present embodiment, the inductor current i_{L} represents the test current that is used for the valve performance test.

For the inductor 108, the main valve 102 operates in the rectifier mode and the auxiliary valve 104 operates in the inverter mode, as described above.

The control unit switches the first switch S_{T,i} and the second switch S_{B,i} of each SM to control a circuit connection of the sub-module capacitor C_{SM,i}, and switches each switch pair of the inverter 106 to control a circuit connection of the DC power supply V_{DC}.

Hereinafter, in the description of the present embodiment, a phrase "control a circuit connection of components of the test device 100" means controlling switches related to the components to adjust operations of the components in the test device 100.

In the illustration of FIG. 1, a test current i_{L} is determined according to an inductor voltage v_{L}, and the inductor voltage in the loop is equal to a voltage obtained by subtracting the input voltage v_{SM} of the main valve 102 from a sum of an output voltage vₒ of the inverter 106 and the output voltage vₐᵤₓ of the auxiliary valve 104. This relationship can be expressed as Equation 1. [Equation 1] ${v}_{L} = {v}_{o} + {v}_{aux} - {v}_{SM}$

When the voltages of the capacitors of the auxiliary valve 104 and the main valve 102 are the same, and the number of SMs of the auxiliary valve 104 that have been turned on is the same as the number of SMs of the main valve 102 that have been turned on, vₐᵤₓ and v_{SM} can be offset. Therefore, the inductor voltage v_{L} is adjusted according to the output voltage vo of the inverter 106, such that the test current i_{L} can also be adjusted. Here, a phrase "the SM has been turned on (or is in an on state)" means that the first switch S_{T,i} is turned on and the second switch S_{B,i} is turned off.

Before the test current is adjusted for a performance test, the control unit initially charges the sub-module capacitor for each of the SMs of the main valve 102 and the auxiliary valve 104.

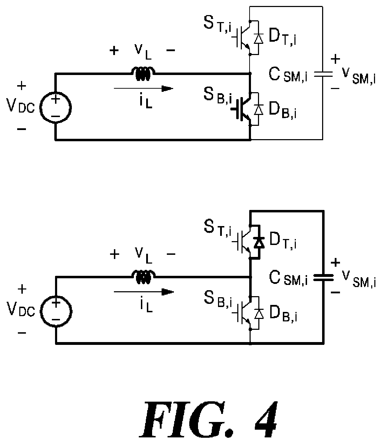

When the second switches of all the SMs of the main valve 102 and the auxiliary valve 104 except for the second switch of the i-th SM of the main valve 102 are turned on, and the first switch pair of the inverter 106 is turned on, an equivalent circuit can be represented as illustrated in FIG. 4. This equivalent circuit has the same form as a boost converter for boosting. Therefore, as illustrated in FIG. 4, the second switch S_{B,i} is switched for the same operation as that of the boost converter, so that the i-th sub-module capacitor can be charged into a voltage higher than that of the DC supply voltage V_{DC}.

The control unit may initially charge the sub-module capacitor for each SM of the auxiliary valve 104 on the basis of the same scheme as that applied to each SM of the main valve 102.

Since the sub-module capacitor is initially charged in the same way, an input v_{SM} of the main valve 102 and an output vₐᵤₓ of the auxiliary valve 104 can be offset in Equation 1. Accordingly, the control unit can control a circuit connection of the inductor 108 using the inverter 106 to generate, for the main valve 102, a test current for testing the main valve 102. As described above, according to the present embodiment, there is an effect that it becomes possible to perform the performance test on a per valve using only the inverter based on the DC power supply having a capacity capable of charging the sub-module capacitor for one SM.

The control unit switches each switch pair of the inverter 106 to generate an AC voltage including a second harmonic wave and a DC offset component. The control unit may adjust a switching cycle of each switch pair of the inverter 106 so that a fundamental frequency of the AC voltage generated by the inverter 106 becomes a frequency (for example, 50 or 60 Hz) of a commercial voltage.

The control unit may adjust a switching duty of each switch pair of the inverter 106 to generate an AC voltage including a DC offset component. In addition, the control unit may switch each switch pair of the inverter 106 using a frequency (for example, several KHz) much higher than the fundamental frequency to generate an AC voltage including the second harmonic wave component. In this case, for example, each switch pair of the inverter 106 may be switched on the basis of a pulse width modulation (PWM) scheme so that the AC voltage can maintain a fundamental frequency component. Further, the control unit may adjust a pulse width generated according to the PWM scheme so that the DC offset component is included in the AC voltage.

The control unit may cause a test current having characteristics similar to the AC voltage to flow through the inductor 108 on the basis of the AC voltage generated by the inverter 106.

When the test current i_{L} of the inductor 108 flows in a direction illustrated in FIG. 1 (hereinafter referred to as a 'positive (+) direction'), the voltage of the sub-module capacitor where S_{T,i} is in an on state with respect to the SM of the main valve 102 increases, and the voltage of the sub-module capacitor where S_{T,i} is in an on state with respect to the SM of the auxiliary valve 104 decreases. When the test current i_{L} flows in a direction opposite to that illustrated in FIG. 1 (hereinafter referred to as a 'negative (-) direction'), the voltage of the sub-module capacitor where S_{T,i} is in an on state with respect to the SM of the main valve 102 decreases, and the voltage of the sub-module capacitor where S_{T,i} is in an on state with respect to the SM of the auxiliary valve 104 increases.

In Equation 1, the control unit can maintain the equal numbers of SMs that have been turned on in the main valve 102 and SMs that have been turned on in the auxiliary valve 104 so that the input v_{SM} of the main valve 102 and the output vₐᵤₓ of the auxiliary valve 104 can be offset. For the convenience of the performance test, the control unit may allow the same number of SMs in the on state to be symmetrically disposed in the main valve 102 and the auxiliary valve 104. Further, the control unit may adjust the number of SMs that have been turned on in the main valve 102 to adjust the number of SMs that are performance test targets. That is, the control unit may perform the performance test on all or some of the n SMs included in the main valve 102.

Meanwhile, the control unit serves to maintain a constant voltage of the sub-module capacitor for each SM of the main valve 102 despite characteristics of the test current including the second harmonic wave and the DC offset component. For example, the control unit switches the first switch and the second switch of the i-th SM of each of the main valve 102 and the auxiliary valve 104 in a direction in which a difference between an average value of a voltage v_{SM,i} of the sub-module capacitor and a preset reference voltage v_{SM,i,ref} is reduced for the i-th SM of the main valve 102.

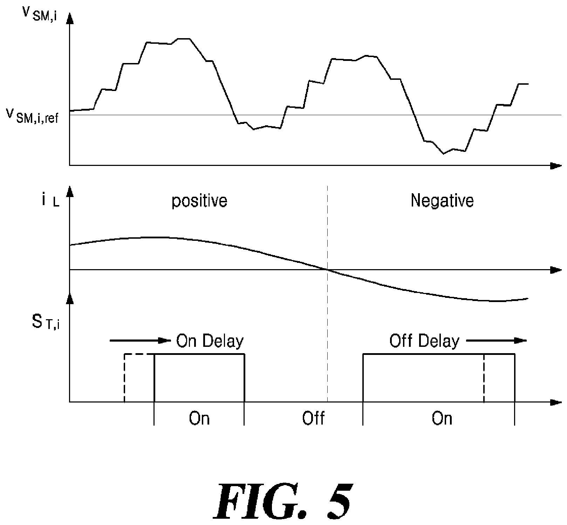

As illustrated in FIG. 5, when the average value of the voltage of the sub-module capacitor is higher than the reference voltage and the test current is in a positive direction, the control unit may delay an on-timing of the first switch S_{T,i} so that a charge time is shorter than a preset charge time. On the other hand, when the average value of the voltage of the submodule capacitor is lower than the reference voltage and the test current is in a negative direction, the control unit delays an off timing of the first switch S_{T,i} so that a discharge time is shorter than a preset discharge time, and thus, the voltage of the sub-module capacitor can follow the reference voltage.

A device (not illustrated) on which the control unit of the test device 100 according to the present embodiment is mounted may be a programmable computer.

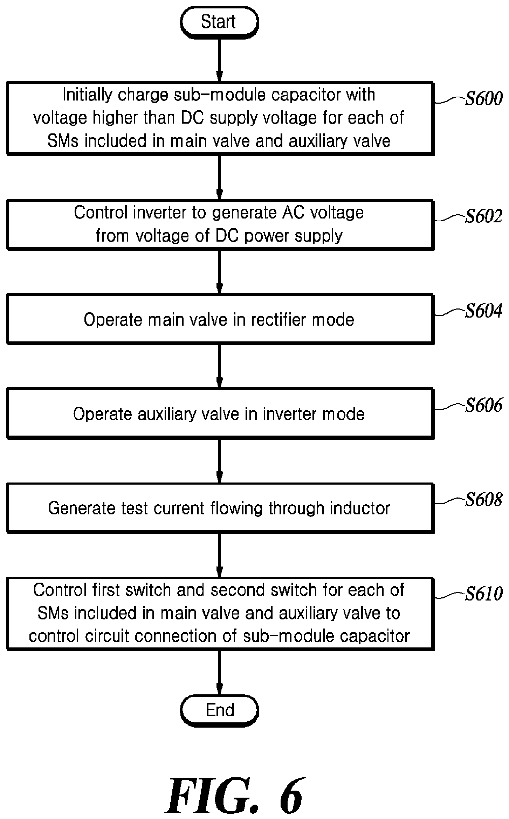

FIG. 6 is a flowchart of a valve performance test method according to an embodiment of the present disclosure.

The control unit of the test device 100 initially charges the sub-module capacitor with a voltage higher than the DC supply voltage for each of the SMs included in the main valve and the auxiliary valve (S600). As illustrated in FIG. 4, the control unit controls a circuit connection of the main valve 102, the auxiliary valve 104, and the inverter 106 for each of the SMs of the main valve 102 and the auxiliary valve 104 to implement a circuit equivalent to the boost converter, and then, switches the second switch to initially charge the sub-module capacitor of each SM with the voltage higher than the DC supply voltage.

The control unit controls the inverter to generate an AC voltage from a voltage of a DC power supply (S602). The control unit generates the AC voltage including the second harmonic wave and the DC offset component by switching each switch pair of the inverter 106. That is, the control unit may control the inverter to control a circuit connection of the DC power supply.

The fundamental frequency of the AC voltage may be set to the frequency (for example, 50 or 60 Hz) of the commercial voltage. The control unit may switch each switch pair of the inverter 106 on the basis of the PWM scheme so that the AC voltage can include the second harmonic wave and the DC offset component, in addition to the fundamental frequency.

The control unit operates the main valve in the rectifier mode (S604).

The control unit operates the auxiliary valve in the inverter mode (S606).

For the inductor 108, the main valve 102 operates in the rectifier mode and the auxiliary valve 104 operates in the inverter mode.

The control unit generates a test current flowing through the inductor (S608). The inverter forms a loop with the input of the main valve, the output of the inverter, and the output of the auxiliary valve. The control unit may cause a test current having characteristics similar to those of an AC voltage to flow through the inductor 108 on the basis of the AC voltage generated by the inverter 106.

The control unit controls the first switch and the second switch for each of the SMs included in the main valve and the auxiliary valve to control the circuit connection of the submodule capacitor (S610).

When the test current i_{L} of the inductor 108 flows in the positive direction, the voltage of the sub-module capacitor where S_{T,i} is in an on state with respect to the SM of the main valve 102 increases. On the other hand, when the test current i_{L} flows in the negative direction, the voltage of the sub-module capacitor where S_{T,i} is in an on state with respect to the SM of the main valve 102 decreases.

In Equation 1, the control unit can maintain the equal numbers of SMs of the main valve 102 that have been turned on and SMs of the auxiliary valve 104 that have been turned on, so that the input v_{SM} of the main valve 102 and the output vₐᵤₓ of the auxiliary valve 104 can be offset.

The control unit serves to maintain a constant voltage of the sub-module capacitor for each SM of the main valve 102. For example, the control unit switches the first switch and the second switch of the i-th SM of each of the main valve 102 and the auxiliary valve 104 in a direction in which a difference between an average value of a voltage v_{SM,i} of the submodule capacitor and a preset reference voltage v_{SM,i,ref} is reduced for the i-th SM of the main valve 102.

Hereinafter, experimental results for an operation of the test device 100 according to the present embodiment will be described on the basis of a simulation.

The number of SMs included in each of the main valve 102 and the auxiliary valve 104 was set to 4, and the simulation was performed using the parameters shown in Table 1.

**[Table 1]**

| Parameter | Value |
|---|---|
| V_{DC} | 1,000(V) |
| v_{SM}, vₐᵤₓ | 2,000(V) |
| i_{L,P-P} | 1,000(A) |
| i_{L,DC} | 100(A) |
| C_{SM}, Cₐᵤₓ | 3.3(mF) |
| L | 3(mF) |

As described above, since the capacitor of each of the SMs of the main valve 102 and the auxiliary valve 104 is initially charged with the voltage higher than the DC supply voltage, v_{SM} and vₐᵤₓ are set to values greater than V_{DC} in Table 1.

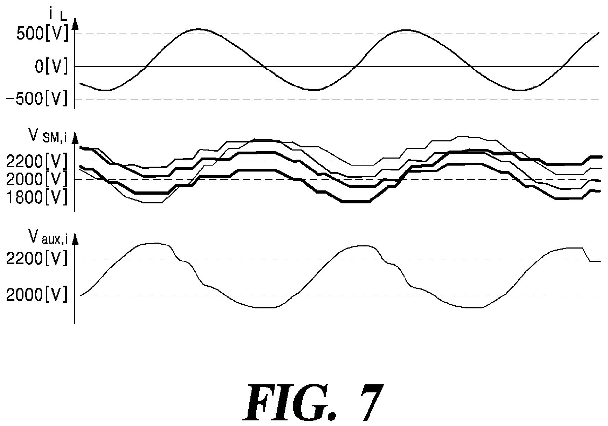

FIG. 7 is an illustrative diagram illustrating simulation results for the test device according to the embodiment of the present disclosure.

For a simulation performed on a per valve, FIG. 7 illustrates simulation results for the test current and the voltage of the capacitor for the i-th SM of each of the main valve 102 and the auxiliary valve 104. It can be confirmed from the simulation results illustrated in FIG. 7 that the test current includes the second harmonic wave and the DC offset component. It can also be confirmed that a constant average voltage of the capacitor of the i-th SM of each of the main valve 102 and the auxiliary valve 104 is maintained to match a reference voltage (2,000 V).

Further, it can be confirmed that in a section in which the test current is positive, the voltage of the capacitor of the i-th SM of the main valve 102 increases, and the voltage of the capacitor of the i-th SM of the auxiliary valve 104 decreases, whereas in a section in which the test current is negative, the voltage of the capacitor of the i-th SM of the main valve 102 decreases, and the voltage of the capacitor of the i-th SM of the auxiliary valve 104 increases.

Although the steps in the respective flowcharts are described to be sequentially performed, the steps merely instantiate the technical idea of some embodiments of the present disclosure. Therefore, a person having ordinary skill in the art to which this disclosure pertains could perform the steps by changing the sequences described in the respective drawings or by performing two or more of the steps in parallel. Hence, the steps in the respective flowcharts are not limited to the illustrated chronological sequences.

The respective components of the device or method according to the present disclosure may be implemented by hardware or software, or may be implemented by a combination of the hardware and the software. Further, a function of each component may be implemented by software and a microprocessor may be implemented to execute the function of the software corresponding to each component.

Various implementation examples of the systems and techniques described in the present specification may be realized by a digital electronic circuit, an integrated circuit, an FPGA (field programmable gate array), an ASIC (application specific integrated circuit), computer hardware, firmware, software, and/or a combination thereof. These various implementation examples may be implemented by one or more computer programs executable on a programmable system. The programmable system includes at least one programmable processor (which may be a special purpose processor or may be a generalpurpose processor) connected to receive data and instructions from a storage system, at least one input device, and at least one output device and transfer data and instructions to the storage system, the at least one input device, and the at least one output device. The computer programs (also known as programs, software, software applications, or code) include instructions for the programmable processor and are stored in a "computer-readable recording medium".

The computer-readable recording medium includes any type of recording devices in which data that can be read by a computer system is stored. The computer-readable recording medium may be a non-volatile or non-transitory medium, such as a ROM, a CD-ROM, a magnetic tape, a floppy disk, a memory card, a hard disk, a magneto-optical disc, and a storage device. Further, the computer-readable recording medium may be distributed in network-connected computer systems, and computer-readable code may be stored and executed in a distributed manner.

Although embodiments of the present disclosure have been described for illustrative purposes, those having ordinary skill in the art to which this disclosure pertains should appreciate that various modifications, additions, and substitutions are possible, without departing from the scope of the present disclosure. Therefore, embodiments of the present disclosure have been described for the sake of brevity and clarity.

Accordingly, those having ordinary skill in the art to which this disclosure pertains should understand that the scope of the present disclosure is not to be limited by the above explicitly described embodiments but by the claims.

### [Reference Numerals]

100: Valve performance test device
102: Main valve
104: Auxiliary valve
106: Inverter
108: Inductor

## Claims

1. A test device (100) for testing a valve for a modular multi-level converter, MMC, based high voltage direct current, HVDC, system and a medium voltage direct current, MVDC, system, the test device (100) comprising:
a main valve (102) including n, n is a natural number, first sub-modules (110) connected in series and configured to operate in a rectifier mode, wherein each of the first sub-modules (110) has a structure including a half bridge or full bridge circuit including switches (S_{T,I}, S_{B,i}) and diodes (D_{T,I}, D_{B,i}), and a sub-module capacitor (C_{SM,i});
an auxiliary valve (104) including n second sub-modules connected in series and configured to operate in an inverter mode, wherein each of the second sub-modules has the same structure as the first sub-module (110);
an inverter (106) configured to generate an AC voltage from a voltage of a DC power supply;
an inductor (108) forming a loop with an input (v_{SM}) of the main valve (102), an output (vₒ) of the inverter (106), and an output (vₐᵤₓ) of the auxiliary valve (104), a test current (i_{L}) flowing through the inductor (108); and
a control unit configured to control the inverter (106) to control a circuit connection of the DC power supply, and to control the switches (S_{T,I}, S_{B,i}) for the n first sub-modules (110) and the n second sub-modules to control a circuit connection of the sub-module capacitor (C_{SM,i}).

2. The test device (100) of claim 1, wherein the control unit is configured to control a circuit connection of the main valve (102), the auxiliary valve (104), and the inverter (106) for each of the n first sub-modules (110) to implement a circuit equivalent to a boost converter, and control the switches (S_{T,I}, S_{B,i}) to initially charge the sub-module capacitor (C_{SM,i}) with a voltage higher than a voltage of the DC power supply, wherein the control unit is also configured to perform the initial charging on each of the n second sub-modules in the same manner as applied to the first sub-module (110).

3. The test device (100) of claim 1, wherein the control unit is configured to control the inverter (106) so that an AC voltage including a second harmonic wave and a DC offset are generated.

4. The test device (100) of claim 1, wherein the control unit is configured to maintain the equal numbers of the first sub-modules (110) in an on state and the second sub-modules in an on state, so that the input (v_{SM}) of the main valve (102) and the output (vₐᵤₓ) of the auxiliary valve (104) can be offset.

5. The test device (100) of claim 1, wherein the control unit is configured to generate a test current (i_{L}) having characteristics similar to the AC voltage, wherein the control unit is configured to increase a voltage of the sub-module capacitor (C_{SM,i}) of the first sub-module (110) when the test current (i_{L}) flows in a positive direction and decrease the voltage of the sub-module capacitor (C_{SM,i}) of the first sub-module (110) when the test current (i_{L}) flows in a negative direction.

6. The test device (100) of claim 5, wherein the control unit is configured to control, for the first sub-module (110), the switches (S_{T,I}, S_{B,i}) in a direction in which a difference between an average value of the voltage (v_{SM,i}) of the sub-module capacitor (C_{SM,i}) and a preset reference voltage (v_{SM,i,ref}) is reduced.

7. The test device (100) of claim 6, wherein the control unit is configured to delay an on-timing of the first sub-module (110) so that a charge time is reduced when the average value (v_{SM,i}) is higher than the reference voltage (v_{SM,i,ref}) and the test current (i_{L}) flows in the positive direction, and delay an off-timing of the first sub-module (110) so that a discharge time is reduced when the average value (v_{SM,i}) is lower than the reference voltage (v_{SM,i,ref}) and the test current (i_{L}) flows in the negative direction.

8. A test method performed by a test device (100) to test a valve for a modular multilevel converter, MMC, based high voltage direct current, HVDC, system and a medium voltage direct current, MVDC, system, the test method comprising:
controlling an inverter (106) to generate an AC voltage from a voltage of a DC power supply;
operating a main valve (102) including n, n is a natural number, first sub-modules (110) connected in series in a rectifier mode, wherein each of the first sub-modules has a structure including a half bridge or full bridge circuit including switches (S_{T,I}, S_{B,i}) and diodes (D_{T,I}, D_{B,i}), and a sub-module capacitor (C_{SM,i});
operating an auxiliary valve (104) including n second sub-modules connected in series in an inverter mode, wherein each of the second sub-modules has the same structure as the first sub-module (110);
generating a test current (i_{L}) flowing through an inductor (108) forming a loop with an input (v_{SM}) of the main valve (102), an output (vₒ) of the inverter (106), and an output (vₐᵤₓ) of the auxiliary valve (104); and
controlling the switches (S_{T,I}, S_{B,i}) for the n first sub-modules (110) and the n second sub-modules to control a circuit connection of the sub-module capacitor (C_{SM,i}).

9. The test method of claim 8, further comprising:
controlling a circuit connection of the main valve (102), the auxiliary valve (104), and the inverter (106) for each of the n first sub-modules (110) to implement a circuit equivalent to a boost converter, and controlling the switches (S_{T,I}, S_{B,i}) to initially charge the sub-module capacitor (C_{SM,i}) with a voltage higher than a voltage of the DC power supply, and also performing the initial charging on each of the n second sub-modules in the same manner as applied to the first sub-module (110).

## Patentansprüche

1. Eine Testvorrichtung (100) zum Testen eines Ventils für ein auf einem modularen Multilevel-Wandler, MMC, basierendes Hochspannungs-Gleichstrom-System, HVDC-System, und ein Mittelspannungs-Gleichstrom-System, MVDC-System, wobei die Testvorrichtung (100) Folgendes beinhaltet:
ein Hauptventil (102), das Folgendes umfasst: n, wobei n eine natürliche Zahl ist, erste Submodule (110), die in Reihe geschaltet sind, und das konfiguriert ist, um in einem Gleichrichtermodus zu arbeiten, wobei jedes der ersten Submodule (110) eine Struktur aufweist, die eine Halbbrücken- oder Vollbrückenschaltung, die Schalter (S_{T,I}, S_{B,i}) und Dioden (D_{T},_{I}, D_{B,i}) umfasst, und einen Submodulkondensator (C_{SM,i}) umfasst;
ein Hilfsventil (104), das n zweite Submodule umfasst, die in Reihe geschaltet sind, und das konfiguriert ist, um in einem Wechselrichtermodus zu arbeiten, wobei jedes der zweiten Submodule die gleiche Struktur wie das erste Submodul (110) aufweist;
einen Wechselrichter (106), der konfiguriert ist, um aus einer Spannung einer Gleichstromversorgung eine Wechselspannung zu erzeugen;
eine Induktivität (108), die mit einem Eingang (v_{SM}) des Hauptventils (102), einem Ausgang (vₒ) des Wechselrichters (106) und einem Ausgang (vₐᵤₓ) des Hilfsventils (104) eine Schleife bildet, wobei ein Teststrom (i_{L}) durch die Induktivität (108) fließt; und
eine Steuereinheit, die konfiguriert ist, um den Wechselrichter (106) zu steuern, um eine Schaltungsverbindung der Gleichstromversorgung zu steuern, und um die Schalter (S_{T,I}, S_{B,i}) für die n ersten Submodule (110) und die n zweiten Submodule zu steuern, um eine Schaltungsverbindung des Submodulkondensators (C_{SM,i}) zu steuern.

2. Testvorrichtung (100) gemäß Anspruch 1, wobei die Steuereinheit konfiguriert ist, um eine Schaltungsverbindung des Hauptventils (102), des Hilfsventils (104) und des Wechselrichters (106) für jedes der n ersten Submodule (110) zu steuern, um eine Schaltung zu implementieren, die einem Aufwärtswandler entspricht, und um die Schalter (S_{T,I}, S_{B,i}) zu steuern, um den Submodulkondensator (C_{SM,i}) anfänglich mit einer Spannung zu laden, die höher als eine Spannung der Gleichstromversorgung ist, wobei die Steuereinheit auch konfiguriert ist, um das anfängliche Laden an jedem der n zweiten Submodule auf die gleiche Weise durchzuführen, wie sie auf das erste Submodul (110) angewandt wird.

3. Testvorrichtung (100) gemäß Anspruch 1, wobei die Steuereinheit konfiguriert ist, um den Wechselrichter (106) so zu steuern, dass eine Wechselspannung, die eine zweite Harmonische und einen DC-Offset umfasst, erzeugt wird.

4. Testvorrichtung (100) gemäß Anspruch 1, wobei die Steuereinheit konfiguriert ist, um die gleichen Anzahlen der ersten Submodule (110) in einem Ein-Zustand und der zweiten Submodule in einem Ein-Zustand zu halten, sodass der Eingang (v_{SM}) des Hauptventils (102) und der Ausgang (vₐᵤₓ) des Hilfsventils (104) einander aufheben können.

5. Testvorrichtung (100) gemäß Anspruch 1, wobei die Steuereinheit konfiguriert ist, um einen Teststrom (i_{L}) zu erzeugen, der Eigenschaften ähnlich der Wechselspannung aufweist, wobei die Steuereinheit konfiguriert ist, um eine Spannung des Submodulkondensators (C_{SM,i}) des ersten Submoduls (110) zu erhöhen, wenn der Teststrom (i_{L}) in einer positiven Richtung fließt, und die Spannung des Submodulkondensators (C_{SM,i}) des ersten Submoduls (110) zu verringern, wenn der Teststrom (i_{L}) in einer negativen Richtung fließt.

6. Testvorrichtung (100) gemäß Anspruch 5, wobei die Steuereinheit konfiguriert ist, um für das erste Submodul (110) die Schalter (S_{T,I}, S_{B,i}) in einer Richtung zu steuern, in der eine Differenz zwischen einem Durchschnittswert der Spannung (v_{SM,i}) des Submodulkondensators (C_{SM,i}) und einer voreingestellten Referenzspannung (v_{SM,i,ref}) verringert wird.

7. Testvorrichtung (100) gemäß Anspruch 6, wobei die Steuereinheit konfiguriert ist, um einen Ein-Zeitpunkt des ersten Submoduls (110) zu verzögern, sodass eine Ladezeit verringert wird, wenn der Durchschnittswert (v_{SM,i}) höher als die Referenzspannung (v_{SM,i,ref}) ist und der Teststrom (i_{L}) in der positiven Richtung fließt, und um einen Aus-Zeitpunkt des ersten Submoduls (110) zu verzögern, sodass eine Entladezeit verringert wird, wenn der Durchschnittswert (v_{SM,i}) niedriger als die Referenzspannung (v_{SM,i,ref}) ist und der Teststrom (i_{L}) in der negativen Richtung fließt.

8. Ein Testverfahren, das von einer Testvorrichtung (100) zum Testen eines Ventils für ein auf einem modularen Multilevel-Wandler, MMC, basierendes Hochspannungs-Gleichstrom-System, HVDC-System, und ein Mittelspannungs-Gleichstrom-System, MVDC-System, durchgeführt wird, wobei das Testverfahren Folgendes beinhaltet:
Steuern eines Wechselrichters (106), um aus einer Spannung einer Gleichstromversorgung eine Wechselspannung zu erzeugen;
Betreiben, in einem Gleichrichtermodus, eines Hauptventils (102), das Folgendes umfasst: n, wobei n eine natürliche Zahl ist, erste Submodule (110), die in Reihe geschaltet sind, wobei jedes der ersten Submodule eine Struktur aufweist, die eine Halbbrücken- oder Vollbrückenschaltung, die Schalter (S_{T,I}, S_{B,i}) und Dioden (D_{T},_{I}, D_{B},ᵢ) umfasst, und einen Submodulkondensator (C_{SM,i}) umfasst;
Betreiben, in einem Wechselrichtermodus, eines Hilfsventils (104), das n zweite Submodule umfasst, die in Reihe geschaltet sind, wobei jedes der zweiten Submodule die gleiche Struktur wie das erste Submodul (110) aufweist;
Erzeugen eines Teststroms (i_{L}), der durch eine Induktivität (108) fließt, die mit einem Eingang (v_{SM}) des Hauptventils (102), einem Ausgang (vₒ) des Wechselrichters (106) und einem Ausgang (vₐᵤₓ) des Hilfsventils (104) eine Schleife bildet; und
Steuern der Schalter (S_{T,I}, S_{B,i}) für die n ersten Submodule (110) und die n zweiten Submodule, um eine Schaltungsverbindung des Submodulkondensators (C_{SM,i}) zu steuern.

9. Testverfahren gemäß Anspruch 8, das ferner Folgendes beinhaltet:
Steuern einer Schaltungsverbindung des Hauptventils (102), des Hilfsventils (104) und des Wechselrichters (106) für jedes der n ersten Submodule (110), um eine Schaltung zu implementieren, die einem Aufwärtswandler entspricht, und Steuern der Schalter (S_{T,I}, S_{B,i}), um den Submodulkondensator (C_{SM,i}) anfänglich mit einer Spannung zu laden, die höher als eine Spannung der Gleichstromversorgung ist, und auch Durchführen des anfänglichen Ladens an jedem der n zweiten Submodule auf die gleiche Weise, wie sie auf das erste Submodul (110) angewandt wird.

## Revendications

1. Un dispositif d'essai (100) pour tester une valve pour un système à courant continu haute tension, HVDC, à base de convertisseur multi-niveau modulaire, MMC, et un système à courant continu moyenne tension, MVDC, le dispositif d'essai (100) comprenant :
une valve principale (102) incluant n, n étant un nombre naturel, premiers sous-modules (110) connectés en série et configurés pour fonctionner dans un mode redresseur, où chacun des premiers sous-modules (110) présente une structure incluant un circuit en demi-pont ou en pont complet incluant des commutateurs (S_{T,I}, S_{B,i}) et des diodes (D_{T,I}, D_{B,i}), et un condensateur de sous-module (C_{SM,i}) ;
une valve auxiliaire (104) incluant n deuxièmes sous-modules connectés en série et configurés pour fonctionner dans un mode onduleur, où chacun des deuxièmes sous-modules présente la même structure que le premier sous-module (110) ;
un onduleur (106) configuré pour générer une tension alternative à partir d'une tension d'une alimentation en courant continu ;
une inductance (108) formant une boucle avec une entrée (v_{SM}) de la valve principale (102), une sortie (vₒ) de l'onduleur (106), et une sortie (vₐᵤₓ) de la valve auxiliaire (104), un courant d'essai (i_{L}) circulant à travers l'inductance (108) ; et
une unité de commande configurée pour commander l'onduleur (106) afin de commander une connexion de circuit de l'alimentation en courant continu, et pour commander les commutateurs (S_{T,I}, S_{B,i}) pour les n premiers sous-modules (110) et les n deuxièmes sous-modules afin de commander une connexion de circuit du condensateur de sous-module (C_{SM,i}).

2. Le dispositif d'essai (100) de la revendication 1, où l'unité de commande est configurée pour commander une connexion de circuit de la valve principale (102), de la valve auxiliaire (104), et de l'onduleur (106) pour chacun des n premiers sous-modules (110) pour mettre en œuvre un circuit équivalent à un convertisseur élévateur, et commander les commutateurs (S_{T,I}, S_{B,i}) pour charger initialement le condensateur de sous-module (C_{SM,i}) avec une tension supérieure à une tension de l'alimentation en courant continu, où l'unité de commande est également configurée pour réaliser la charge initiale sur chacun des n deuxièmes sous-modules de la même manière que celle appliquée au premier sous-module (110).

3. Le dispositif d'essai (100) de la revendication 1, où l'unité de commande est configurée pour commander l'onduleur (106) de sorte qu'une tension alternative incluant une onde harmonique de rang deux et un décalage continu soit générée.

4. Le dispositif d'essai (100) de la revendication 1, où l'unité de commande est configurée pour maintenir égaux les nombres des premiers sous-modules (110) dans un état passant et des deuxièmes sous-modules dans un état passant, de sorte que l'entrée (v_{SM}) de la valve principale (102) et la sortie (vₐᵤₓ) de la valve auxiliaire (104) puissent être décalées.

5. Le dispositif d'essai (100) de la revendication 1, où l'unité de commande est configurée pour générer un courant d'essai (i_{L}) ayant des caractéristiques similaires à la tension alternative, où l'unité de commande est configurée pour augmenter une tension du condensateur de sous-module (C_{SM,i}) du premier sous-module (110) lorsque le courant d'essai (i_{L}) circule dans un sens positif et diminuer la tension du condensateur de sous-module (C_{SM,i}) du premier sous-module (110) lorsque le courant d'essai (i_{L}) circule dans un sens négatif.

6. Le dispositif d'essai (100) de la revendication 5, où l'unité de commande est configurée pour commander, pour le premier sous-module (110), les commutateurs (S_{T,I}, S_{B,i}) dans un sens dans lequel une différence entre une valeur moyenne de la tension (v_{SM,i}) du condensateur de sous-module (C_{SM,i}) et une tension de référence prédéfinie (v_{SM,i,ref}) est réduite.

7. Le dispositif d'essai (100) de la revendication 6, où l'unité de commande est configurée pour retarder un instant d'activation du premier sous-module (110) de sorte qu'un temps de charge soit réduit lorsque la valeur moyenne (v_{SM,i}) est supérieure à la tension de référence (v_{SM,i,ref}) et que le courant d'essai (i_{L}) circule dans le sens positif, et retarder un instant de désactivation du premier sous-module (110) de sorte qu'un temps de décharge soit réduit lorsque la valeur moyenne (v_{SM,i}) est inférieure à la tension de référence (v_{SM,i,ref}) et que le courant d'essai (i_{L}) circule dans le sens négatif.

8. Un procédé d'essai réalisé par un dispositif d'essai (100) pour tester une valve pour un système à courant continu haute tension, HVDC, à base de convertisseur multi-niveau modulaire, MMC, et un système à courant continu moyenne tension, MVDC, le procédé d'essai comprenant :
la commande d'un onduleur (106) pour générer une tension alternative à partir d'une tension d'une alimentation en courant continu ;
le fonctionnement d'une valve principale (102) incluant n, n étant un nombre naturel, premiers sous-modules (110) connectés en série dans un mode redresseur, où chacun des premiers sous-modules présente une structure incluant un circuit en demi-pont ou en pont complet incluant des commutateurs (S_{T,I}, S_{B,i}) et des diodes (D_{T,I}, D_{B,i}), et un condensateur de sous-module (C_{SM,i}) ;
le fonctionnement d'une valve auxiliaire (104) incluant n deuxièmes sous-modules connectés en série dans un mode onduleur, où chacun des deuxièmes sous-modules présente la même structure que le premier sous-module (110) ;
la génération d'un courant d'essai (i_{L}) circulant à travers une inductance (108) formant une boucle avec une entrée (v_{SM}) de la valve principale (102), une sortie (vₒ) de l'onduleur (106), et une sortie (vₐᵤₓ) de la valve auxiliaire (104) ; et
la commande des commutateurs (S_{T,I}, S_{B,i}) pour les n premiers sous-modules (110) et les n deuxièmes sous-modules afin de commander une connexion de circuit du condensateur de sous-module (C_{SM,i}).

9. Le procédé d'essai de la revendication 8, comprenant en outre :
la commande d'une connexion de circuit de la valve principale (102), de la valve auxiliaire (104), et de l'onduleur (106) pour chacun des n premiers sous-modules (110) pour mettre en œuvre un circuit équivalent à un convertisseur élévateur, et la commande des commutateurs (S_{T,I}, S_{B,i}) pour charger initialement le condensateur de sous-module (C_{SM,i}) avec une tension supérieure à une tension de l'alimentation en courant continu, et également la réalisation de la charge initiale sur chacun des n deuxièmes sous-modules de la même manière que celle appliquée au premier sous-module (110).
